# EUROPEAN PATENT SPECIFICATION

(11) **EP 4 035 417 B1**
(45) Date of publication and mention of the grant of the patent: **11.11.2026**
(21) Application number: 20869610.4
(22) Date of filing: 23.09.2020
(51) Int. Cl.: H04R 3/00, H03F 3/217, H03F 1/52, H03F 3/185, H03F 3/45

(54) **AUDIO PLAYBACK UNDER SHORT CIRCUIT CONDITIONS**
AUDIOWIEDERGABE UNTER KURZSCHLUSSBEDINGUNGEN
LECTURE AUDIO DANS DES CONDITIONS DE COURT-CIRCUIT

(30) Priority: 23.09.2019 US 201962904122 P; 27.07.2020 US 202016939376
(43) Date of publication of application: 03.08.2022
(73) Proprietor: Texas Instruments Incorporated, Dallas, TX 75265 (US)
(72) Inventor: CHAWLA, Mohit, Bengaluru 560102 (IN)
(74) Representative: Zeller, Andreas
(86) International application number: PCT/US2020/052131
(87) International publication number: WO 2021/061714

(56) References cited:
- CN-A- 103 036 494
- CN-A- 107 834 985
- JP-A- 2004 208 216
- JP-A- 2007 235 526
- US-A- 5 805 020
- US-A1- 2013 223 652
- US-A1- 2018 076 781
- US-B2- 7 616 458
- US-B2- 8 384 478
- US-B2- 9 025 791
- "Class D Amplifier Design Basics II", IR INTERNATIONAL RECTIFIER, 19 February 2009 (2009-02-19), XP055811765, Retrieved from the Internet <URL:http://www.irf.com/product-info/audio/classdtutorial2.pdf>

## Description

### BACKGROUND

Many audio output systems include a class-D amplifier configured to drive a speaker. A class-D amplifier includes transistors that are configured to alternate between coupling a supply and a ground to an output. Audio systems that include class-D amplifiers are often integrated into telecommunications equipment such as telephones, etc. In some examples, this telecommunications equipment is integrated into a vehicle, such as an automobile. The audio system that includes the class-D amplifier may be configured to output audio associated with a telecommunications session, such as a phone call.

During operation of an audio system including a class-D amplifier, a short circuit condition may occur in which one of the output terminals of the class-D amplifier is short-circuited to the ground or the supply. In response to such a condition, many audio systems are configured to disable audio output. However, disabling audio altogether may be unsuitable in some situations. For example, disabling audio output of a telecommunications device in an emergency situation, such as after an automobile accident, may be undesirable. US 2018/076781 discloses a class-D amplifier circuit. US 8,384,478 relates to a versatile audio power amplifier. JP 2007 235526 relates to a pulse modulation type power amplifier. JP 2004 208216 discloses a pulse width modulator/amplifier.

### SUMMARY

The invention is defined by the features of the appended claims. An audio system includes an H-bridge. The audio system implements one or more techniques for ensuring a transistor within the H-bridge does not turn on in the event of the detection of a short-circuit on the output of the H-bridge. Other transistors within the H-bridge can turn and thus audio can still be played to a speaker.

In one example, an audio system includes a modulator having an input and an output and an H-bridge having an input and an output. The output of the modulator is coupled to the input of the H-bridge. A load diagnostics circuit is included that has an input and a first control output. A direct current (DC) add circuit is included having an input and an output. The output of the DC add circuit is coupled to the input of the modulator, and the first control output from the load diagnostics circuit is coupled to the DC add circuit.

Another example includes an audio system including a modulator having an input and an output and an H-bridge having an input and an output. A load diagnostics circuit is included having an input and a first control output. A signal masking circuit is coupled between the output of the modulator and the input of the H-bridge. The signal masking circuit includes a control input coupled to the first control output of the load diagnostics circuit.

In a further example, an audio system includes a modulator having an input and an output and an H-bridge having an input and an output. A short-circuit feedback circuit has an input and an output, and the input of the short-circuit feedback circuit is coupled to the output of the modulator. A first switch is coupled between the output of the short-circuit feedback circuit and the input of the modulator. A second switch is coupled between the output of the H-bridge and the input of the modulator. A load diagnostics circuit has an input coupled to the output of the H-bridge. The load diagnostics circuit is configured to control operational states of the first and second switches.

### BRIEF DESCRIPTION OF THE DRAWINGS

For a detailed description of various examples, reference will now be made to the accompanying drawings in which:
FIG. 1 illustrates an example of an audio system including a class-D amplifier.
FIG. 2 illustrates an example of an H-bridge for use in a class-D amplifier.
FIG. 3 shows a timing diagram of signals within a modulator of a class-D amplifier.
FIG. 4 illustrates an example of an audio system that includes a class-D amplifier and a direct current (DC) add circuit to permit the audio system to continue playing audio in the face of a short-circuit of one of the output terminals of the H-bridge.
FIG. 5 illustrates an example of a modulator for use with the class-D amplifier.
FIG. 6 is a timing diagram illustrating adding negative DC to the audio signal upon the detection of certain types of short-circuits.
FIG. 7 is a timing diagram illustrating adding positive DC to the audio signal upon the detection of other types of short-circuits.
FIG. 8 illustrates an implementation of an audio system that includes a signal masking circuit.
FIG. 9 illustrates an example of an audio system that includes a dummy feedback loop.
FIG. 10 illustrates an example of an audio system that includes a DC add circuit, a signal masking block, and a dummy feedback loop.
FIG. 11 shows an example implementation of a load diagnostics circuit to detect the presence of a short-circuit on the output of the audio amplifier.

### DETAILED DESCRIPTION OF EXAMPLE EMBODIMENTS

Audio devices that incorporate a class-D amplifier and support audio output under short-circuit conditions are described. A telecommunication device utilizing the described principles may continue to provide audio output even under short-circuit conditions. Accordingly, the telecommunication device may support emergency calls even when the telecommunication device is experiencing a short-circuit condition. The quality of the audio may be impaired due to the short-circuit condition but may be sufficient for emergency or other situations.

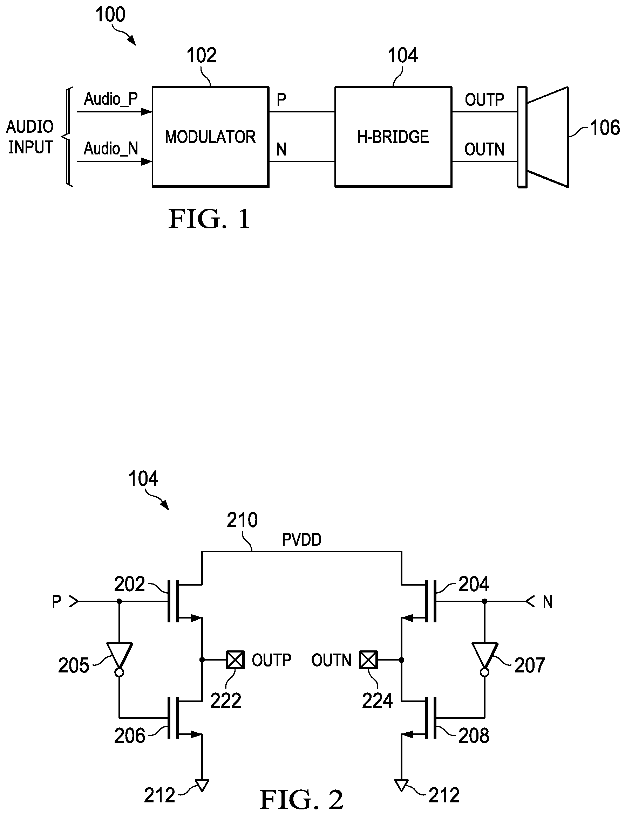

FIG. 1 illustrates at least a portion of an audio system 100. The audio system 100 includes a modulator 102, an H-bridge 104, and a speaker 106. The modulator 102 receives a differential audio input signal comprising Audio_P and Audio_N. The modulator 102 generates output pulse width modulated signals P and N, which are coupled to the H-bridge 104. The H-bridge 104 includes multiple transistor switches and includes output terminals coupled to the speaker 106. The output terminals provide the signal labeled OUTP and OUTM.

FIG. 2 shows an example of H-bridge 104. In this example, H-bridge 104 includes transistors 202, 204, 206, and 208. In the example of FIG. 2, transistors 202-208 comprise N-type metal oxide semiconductor field effect transistors (NMOS) but can be implemented as other types of transistors. A drain of transistor 202 is coupled to a power supply terminal 210 (PVDD) and a source of transistor 202 is coupled to a first output node 222 (OUTP) and to a drain of transistor 206. A source of transistor 206 is coupled to a ground 212. The gate of transistor 202 receives the P signal from modulator 102 and the gate of transistor 206 receives an inverted control signal (via inverter 205). As such, when P is logic high, transistor 202 is on and transistor 206 is off, and when P is logic low, transistor 202 is off and transistor 206 is on. The drain of transistor 204 is also coupled to the power supply terminal 210 (PVDD) and the source of transistor 204 is coupled to a second output node 224 (OUTN) and to the drain of transistor 208. The source of transistor 208 is coupled to the ground 212. The gate of transistor 204 receives the N signal from the modulator and the gate of transistor 108 receives the logical inverse of N (via inverter 207).

A load (such as speaker 106) may be connected between the first output node 222 and the second output node 224 of H-bridge 104. Transistors 202-208 operate as switches (on or off). During normal operation (i.e., no short-circuit conditions), the P and N signals from the modulator 102 cause transistors 202-208 to be configured in any of the following modes: transistors 202 and 208 are on while transistors 204 and 206 are off, transistors 204 and 206 are on while transistors 202 and 208 are off, or transistors 206 and 208 are on, while transistors 202 and 204 are off. At no time should both transistors on one side of the H-bridge be on. That is, transistors 202 and 206 should never be on at the same time. Similarly, transistors 204 and 208 should never be on at the same time. If both transistors on one side of the H-bridge 104 were on at the same time, the supply voltage terminal 210 would effectively be shorted to ground 212.

Unfortunately, shorts may occur within the H-bridge 104. For example, output node 222 (OUTP) may be shorted to ground 212 or to the supply voltage terminal 210. Similarly, output node 224 (OUTN) may be shorted to ground 212 or to the supply voltage terminal 210. If OUTP was inadvertently shorted to ground, a short-circuit condition would occur if transistor 202 was turned on. If OUTP was shorted to the supply voltage terminal 210, a short-circuit condition would occur if transistor 206 was turned on. Similarly, if OUTN was shorted to ground, a short-circuit condition would occur if transistor 204 was turned on, and if OUTN was shorted to the supply voltage terminal 210, a short-circuit condition would occur if transistor 208 was turned on.

In such short-conditions conditions, some audio systems may respond by disabling the audio amplifier altogether to prevent a battery (e.g., an automobile battery) that supplies power to the audio system (to the supply voltage terminal 210) from draining and to prevent damage to other devices and electronics that share the power supply terminal 210. However, shutting down the audio system will prevent any audio at all from through speaker 106. Cessation of all audio may be undesirable in various situations, such emergencies. The examples described herein permit at least some audio to play through speaker 106 despite the presence of a short on one of the H-bridge output nodes 222, 224.

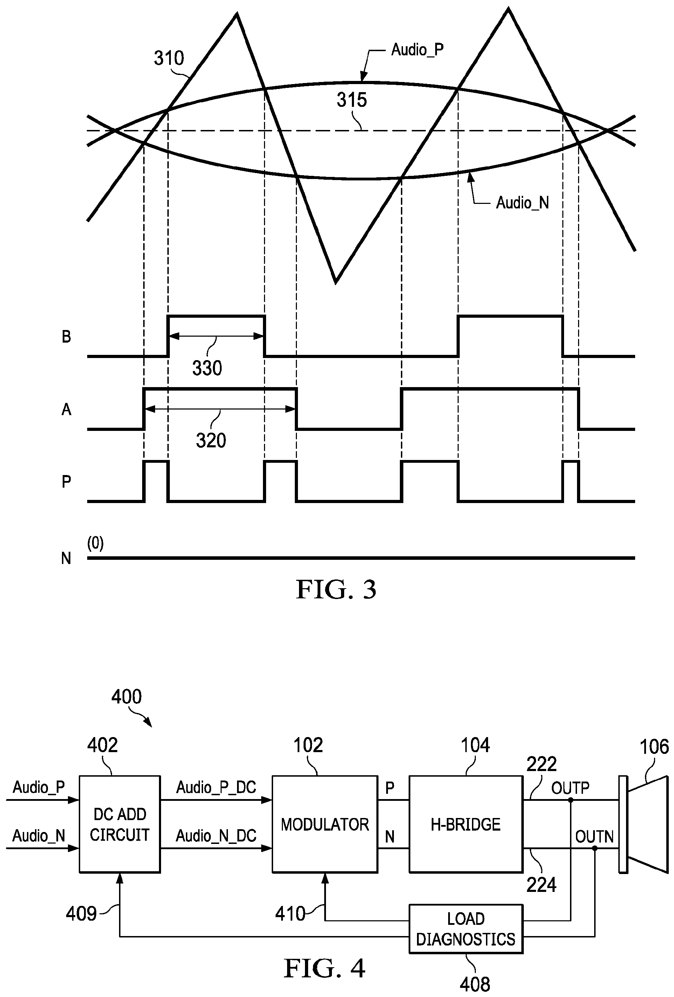

FIG. 3 is a timing diagram illustrating the operation of the modulator 102 when no short-circuit is present on an output node of the H-bridge 104. The differential audio signal is shown as Audio_P and Audio-N. Audio_P and Audio_N may be digital signals. The audio signal is encoded as the difference between Audio_P and Audio_N. Dashed line 315 represents the common mode voltage level of Audio_P and Audio_N. The modulator 102 implements, or receives, a ramp signal 310. The modulator also includes a comparator which generates an output signal B based on a comparison of Audio_P to ramp signal 310 and an output signal A based on a comparison of Audio_N to ramp signal 310. When ramp signal 310 is greater than Audio_P, B is high, and B is low otherwise. Similarly, when ramp signal 310 is greater than Audio_N, A is high, and A is low otherwise. Other logic (shown and described below) within modulator 102 generates the P and N signals. In the example of FIG. 3, Audio_N is more positive than Audio P (a negative audio signal), and thus the width of the A pulses 320 is larger than the width of the B pulses 330. The P signal is determined as A-B when A-B is greater than 0, otherwise P is 0. As such, P is high when A is high and B is low, and P is low otherwise. The N signal is determined as B-A when B-A is greater than 0, otherwise N is 0. As such, N is high when B is high and A is low, and N is low otherwise. In Fig. 3, because B is not high when A is low, N remains at logic low.

FIG. 3 thus illustrates that P pulses on and off as shown and N remains low. Referring briefly to FIG. 2, with P pulsing on and off, transistor 202 is also pulsed on and off. Transistor 202 is turned on when P is high and off when P becomes low. Transistor 206 toggles on and off reciprocal to transistor 202 such transistors 202 and 206 are not on at the same time. With N low, however, transistor 204 remains off and transistor 208 remains on. FIG. 3 shows an example of a negative audio signal (Audio_P is less than Audio_N). For a positive audio signal (Audio_P is greater than Audio_N), the timing of the signals is similar, but the N signal pulses on and off while P remains low.

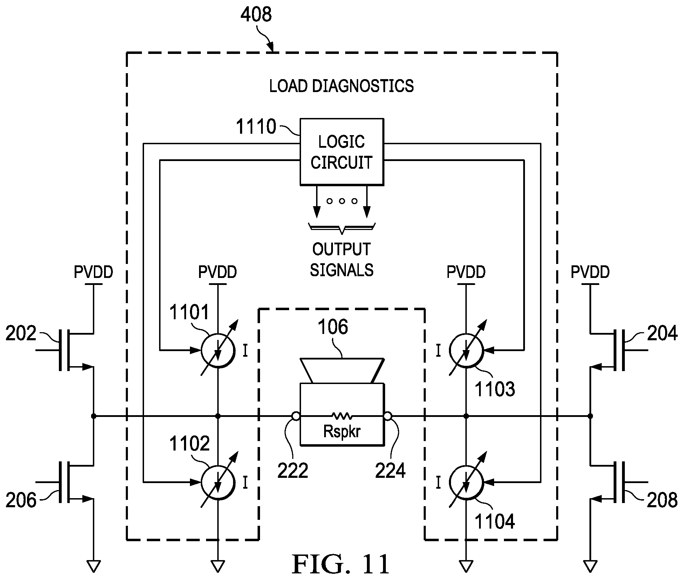

FIG. 4 shows an example of an audio system 400 that includes modulator 102, H-bridge 104, and speaker 106. The audio system 400 also includes a load diagnostics circuit 408 and a direct current (DC) add circuit 402. The load diagnostics circuit 408 monitors the output nodes 222 and 224 of the H-bridge 104 to detect if either of the output nodes 222 or 224 is shorted to ground or to the supply voltage terminal. The output signal 409 indicates whether or not a short-circuit condition has been detected and whether the DC add circuit 402 is to add a DC value (positive or negative) to the audio signal. Control signal 410 is coupled to the modulator 102 and is used to control multiplexers within the modulator as described below. FIG. 11 shows an example implementation of a load diagnostics circuit 408 and is described below.

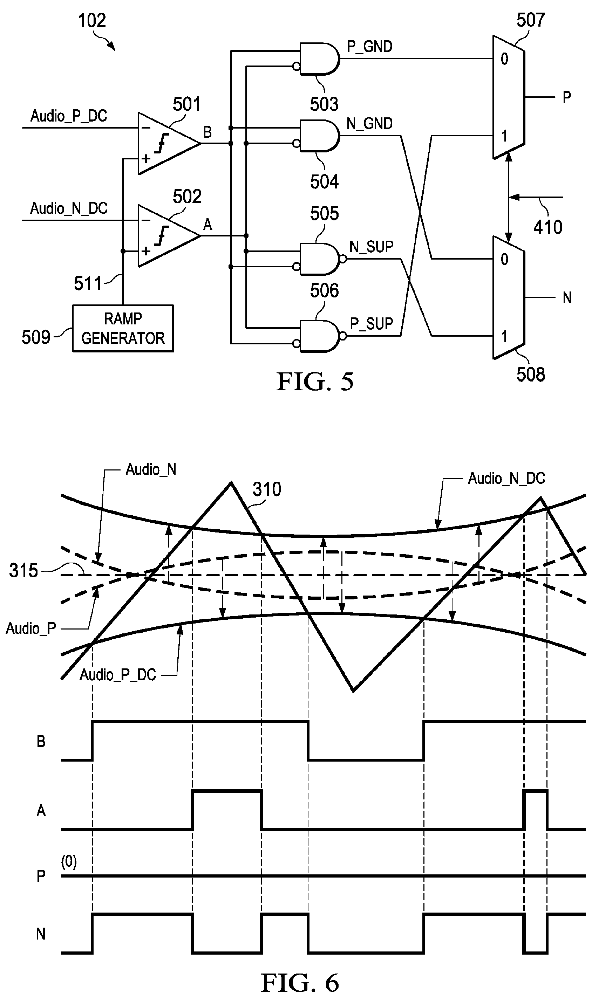

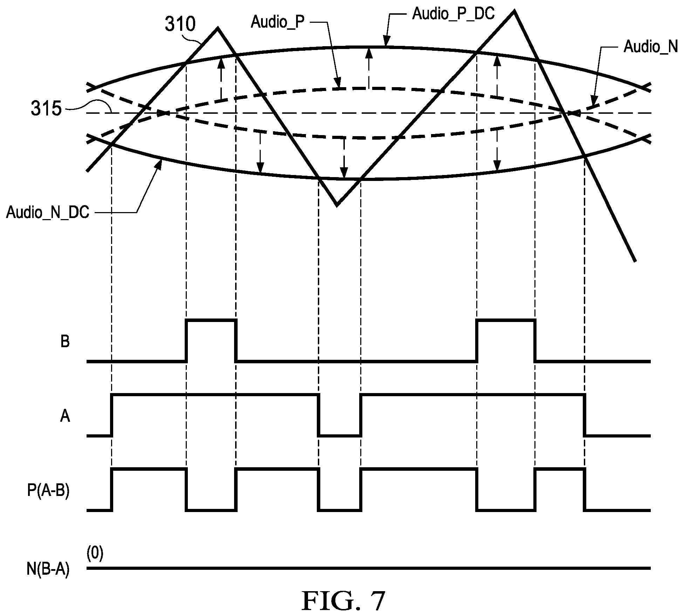

The DC add circuit 402 has inputs that receive Audio_P and Audio_N and the output signal 409 from the load diagnostics circuit 408. The output signals from the DC add circuit 402 include Audio_DC_P and Audio_DC_N. The DC add circuit 402 may be implemented as a digital summer to either add a positive value to the audio signal (the audio signal being the difference between Audio_P and Audio_N) or add a negative value to the audio signal. Neither a positive nor negative value is added to the audio signal if no short-circuit condition is detected by the load diagnostics, and thus Audio_DC_P is equal to Audio_P, and Audio_DC_N is equal to Audio_DC_N. A positive or negative value is added, however, to the audio signal. Whether a positive or negative value is added to the audio signal is a function of the type of short-circuit condition detected by the load diagnostics circuit 408. A positive value is added if the load diagnostics circuit 408 detects that either OUTP is shorted to the supply voltage terminal or OUTN is shorted to ground. A negative value is added if the load diagnostics circuit 408 detects that either OUTP is shorted to ground or OUTN is shorted to the supply voltage terminal. FIG. 5 provides an example implementation of modulator 102 and FIGS. 6 and 7 provide example timing diagrams illustrating the addition of negative and positive values to the audio signal.

In FIG. 5, the example modulator 102 includes comparators 501 and 502, a ramp generator 509, AND gates 503 and 504, NAND gates 505 and 506, and multiplexers 507 and 508. Audio_P_DC is provided to a negative input of comparator 501 and Audio_N_DC is provided to the negative input of comparator 502. Ramp generator 509 generates the ramp signal 310 which is provided to the positive inputs of comparators 501 and 502 to generate the A and B signals.

Each AND gate 503 and 504 and NAND gate 505 and 506 include a non-inverting and an inverting input as shown. The A signal is provided to the non-inverting inputs of AND gate 503 and NAND gate 505 and to the inverting inputs of AND gate 504 and NAND gate 506. Similarly, the B signal is provided to the inverting inputs of AND gate 503 and NAND gate 505 and to the non-inverting inputs of AND gate 504 and NAND gate 506. The output of AND gate 503 is a signal labeled P_GND. P_GND is only high when A is high and B is low, and otherwise P_GND is low. The output of AND gate 504 is a signal labeled N_GND. NM_GND is only high when B is high and A is low, and otherwise N_GND is low. The output of NAND gate 505 is a signal labeled N_SUP. N_SUP is only low when A is high and B is low, and otherwise N_SUP is high. The output of NAND gate 506 is a signal labeled P_SUP. P_SUP is only low when B is high and A is low, and otherwise P_SUP is high.

The 0-input of multiplexer 507 receives P_GND and the 1-input of multiplexer 507 receives P_SUP. The output of multiplexer 507 is the P signal to the H-bridge 104. The 0-input of multiplexer 508 receives N_GND and the 1-input of multiplexer 508 receives N_SUP. The output of multiplexer 508 is the N signal.

The control signal to the multiplexers 507 and 508 is the control signal 410 from the load diagnostics circuit 408. Responsive to the load diagnostics circuit detecting a short between OUTP and ground or between OUTN and ground, the control signal 410 is asserted to cause the multiplexers 507 and 508 to select their 0-inputs. Responsive to the load diagnostics circuit detecting a short between OUTP and the supply voltage terminal or between OUTN and the supply voltage r terminal ail, the control signal 410 is asserted to cause the multiplexers 507 and 508 to select their 1-inputs. When no short-circuit is detected, control signal 410 is asserted to cause the multiplexers 507 and 508 to select their 0-inputs.

If a short occurs between OUTP and ground, the modulator 102 should not permit transistor 202 to turn on. If a short occurs between OUTP and the supply voltage terminal 210, the modulator 102 should not permit transistor 206 to turn on. To prevent NMOS transistor 202 from turning on, modulator 102 forces the P signal to remain at a logic low level. To prevent NMOS transistor 206 from turning on, modulator 102 forces the P signal to remain at a logic high level. Similarly, if a short occurs between OUTN and ground, the modulator 102 should not permit transistor 204 to turn on. If a short occurs between OUTN and the supply voltage terminal 210, the modulator 102 should not permit transistor 208 to turn on. To prevent transistor 204 from turning on, modulator 102 forces the N signal to remain at a logic low level. To prevent transistor 208 from turning on, modulator 102 forces the N signal to remain at a logic high level.

FIG. 6 is a timing diagram illustrating how the system reacts to the presence of short-circuit detected by load diagnostics 408 between OUTP and ground. For that case, a negative DC value is added to the audio signal. Adding a negative DC value results in the difference between Audio_P and Audio_N being more negative. FIG. 6 illustrates that Audio_N is increased to a more positive level while Audio_P is made more negative. A large enough negative DC value is added such that Audio_N_DC and Audio_P_DC do not cross each other. The common mode level 315 of Audio_N_DC and Audio_P_DC does not change.

The resulting A and B comparator output signals are shown in FIG. 6 as well. The P signal remains at logic low because A-B is not greater than 0. However, the N signal pulses high and low as shown. With P being forced to remain low, transistor 202 cannot turn on and transistor 206 remains on. Transistor 204 pulses on and off in accordance with the N signal, and audio can be played (albeit at reduced quality) through the speaker.

FIG. 7 is a timing diagram illustrating how the system reacts to the presence of short-circuit detected by load diagnostics 408 between OUTN and ground. For that case, a positive DC value is added to the audio signal. Adding a positive DC value results in the difference between Audio_P and Audio_N being more positive. FIG. 7 illustrates that Audio_P is increased to a more positive level while Audio_N is made more negative. A large enough positive DC value is added such that Audio_P_DC and Audio_N_DC do not cross each other. The N signal remains at logic low because B-A is not greater than 0. However, the P signal pulses high and low as shown. With N being forced to remain low, transistor 204 cannot turn on and transistor 208 remains on. Transistor 202 pulses on and off in accordance with the P signal, and audio can be played (albeit at reduced quality) through the speaker.

FIGS. 6 and 7 illustrate the response to short-circuits between OUTP and ground and between OUTN and ground. In the case of a short-circuit between OUTP and the supply voltage terminal, the load diagnostics circuit 408 asserts signal 409 to the DC add circuit 402 to cause the DC add circuit 402 to add a positive value to the audio signal, and asserts control signal 410 to cause multiplexers 507 and 508 to select their 1-inputs. Similarly, for a short-circuit between OUTN and the supply voltage terminal, signals 409 and 410 are asserted to cause the DC add circuit 402 to add a negative DC value to the audio signal and to cause the multiplexers to select their 1-inputs.

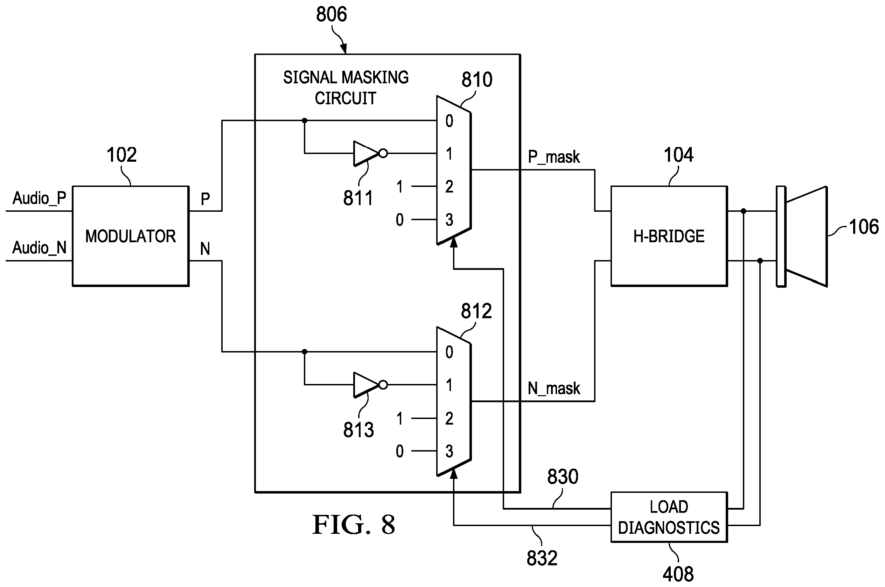

FIG. 8 shows another implementation of an audio system 800 in which a signal masking circuit 806 is provided between the modulator 102 and the H-bridge 104. The signal masking circuit 806 permits the P and N signals to be provided through to the H-bridge when no short-circuit is detected by the load diagnostics circuit 408, and force the P or N signal to be logic low or high (as described above) based on the particular short-circuit condition detected.

The signal masking circuit 806 includes multiplexers 810 and 812 and inverters 811 and 813. Each multiplexer 810, 812 in this example includes at least four inputs 0-3. The 0-input of multiplexer 810 is coupled to output of modulator 102 and receives the P signal. The P signal is inverted by inverter 811, whose output is coupled to the 1-input of multiplexer 810. The 2- and 3-inputs of multiplexer 810 are connected to logic high (1) and low (0), respectively. The 0- through 3-inputs of multiplexer 812 are similarly configured for the N signal. The N signal from modulator 102 is provided to the 0-input of multiplexer 812. The logical inverse of the N signal is provided to the 1-input via inverter 813, and logic high and low are provided to the 2- and 3-inputs of multiplexer 812, respectively.

As described above, the load diagnostics circuit 408 detects the four possible short-circuit conditions on the output of H-bridge 104 (OUTP shorted to the supply voltage terminal, OUTP shorted to ground, OUTM shorted to the supply voltage terminal, and OUTM shorted to ground). Control signals 830 and 832 encode the four possible short-circuit conditions and are used as the selection signals to the multiplexers. For example, if OUTP is shorted to ground, then control signal 830 causes multiplexer 810 to select its 3-input, which is logic low (0). The output of multiplexer 810 is labeled P_MASK and the output of multiplexer 812 is labeled N_MASK. Whereas in the example of FIG. 4, the P and N signals control the H-bridge 104 directly, in the example of FIG. 8, the P_MASK and N_ MASK signals instead control the H-bridge 104.

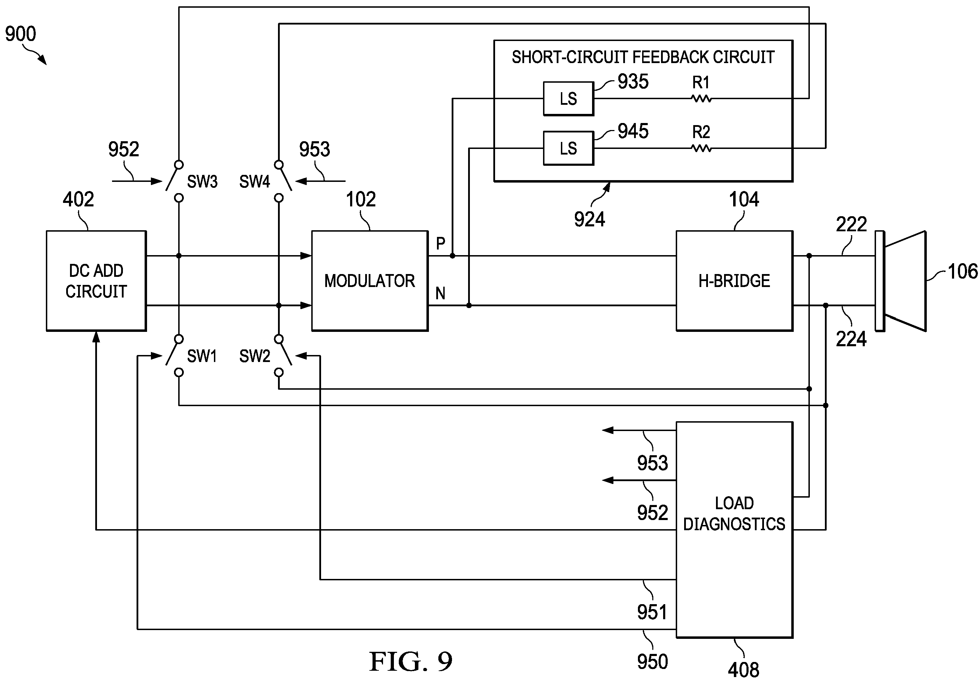

Referring to FIG. 9, an illustration of an audio system 900 including a short-circuit feedback circuit 924 in a feedback loop. The audio system 900 includes the DC add circuit 402, modulator 102, H-bridge 104, speaker 106, and load diagnostics circuit 408. The short-circuit feedback circuit 924 includes a level shifter (LS) 925 coupled to a resistor R1 provided in the P signal line. Similarly, the short-circuit feedback circuit 924 includes a level shifter (LS) 945 coupled to a resistor R2 provided in the N signal line.

With no output short-circuit conditions, the output DC is equal to the input DC. That is, the DC level at the output nodes 222 and 224 is equal to the DC voltage level of the input audio signal, which with no short-circuit condition the input DC is 0V. However, if output node 222 or 224 is shorted to the supply voltage node 210 or ground 212, the output DC will no longer be approximately equal to the input DC thereby causing the modulator to saturate (either 0% or 100% duty cycle). To address this potential problem, the load diagnostics circuit 408 generates control signals 950-953 to switches SW1-SW4. SW1 and SW2 operationally couple respective output nodes 224 and 222 to inputs of the modulator 102, and SW3 and SW4 operationally couple the short-circuit feedback circuit 924 (resistors R1 and R2, respectively) to the inputs of the modulator 102 as shown. The output impedance of short-circuit feedback circuit 924 is higher (e.g., 10x to 100x higher) than the output impedance of H-bridge 104. For example, the output impedance of H-bridge 104 may be approximately 200 milliohms and the output impedance of the short-circuit feedback circuit 924 may be approximately 50 ohms.

Responsive to OUTP being shorted to the supply voltage node or ground, the load diagnostics circuit 408 asserts control signals 951 and 952 to cause SW2 to open and SW3 to close. As such, instead of OUTP from H-bridge 104 being fed back to the input of modulator 102, the feedback signal is provided to the modulator's input from the short-circuit feedback circuit 924 (via resistor R1). Similarly, responsive to OUTM being shorted to the supply voltage node or ground, the load diagnostics circuit 408 asserts control signals 950 and 953 to cause SW1 to open and SW4 to close. As such, instead of OUTM from H-bridge 104 being fed back to the input of modulator 102, the feedback signal is provided to the modulator's input from the short-circuit feedback circuit 924 (via resistor R2). In another implementation, both SW1 and SW2 can be open and SW3 and SW4 closed in the case of a short-circuit fault detection. The voltages produced by the level-shifters 935, 945 and the value of the resistances of R1 and R2 are application-specific and are set so that the DC level of the output from the short-circuit feedback circuit 924 is approximately equal to the DC level of the audio input signal.

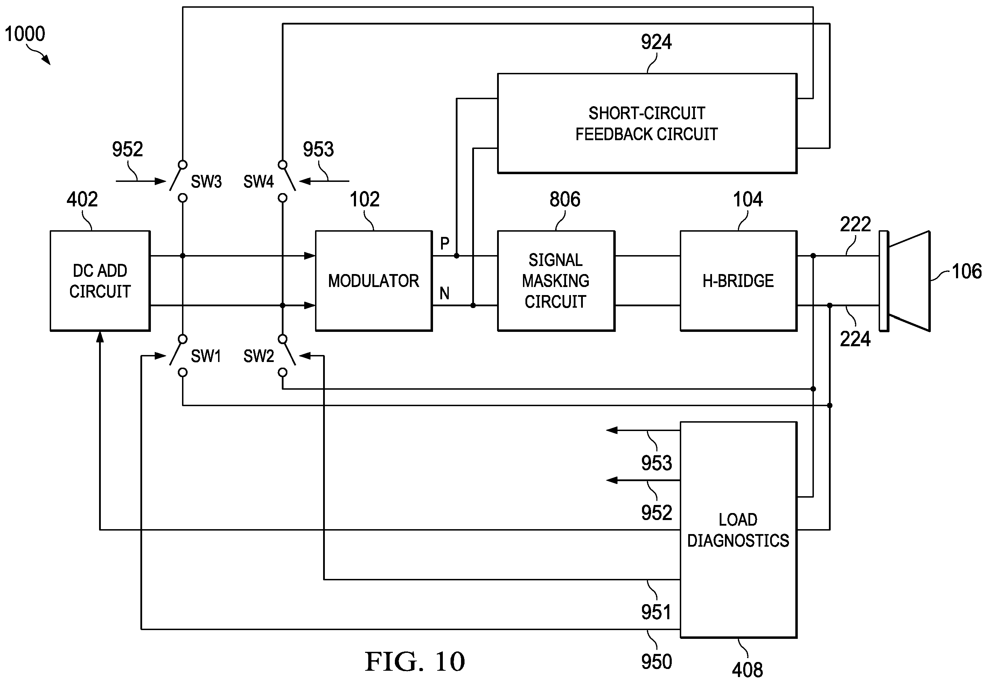

Various aspects of the above-described audio systems may be combined. For example, FIG. 10 depicts an example of an audio system 1000 that includes modulator 102, DC add circuit 402, short-circuit feedback circuit 924, and signal masking circuit 806. Accordingly, in response to detecting a short circuit on an output of H-bridge 104, the audio system 1000 may be configured to prevent a particular transistor within the H-bridge 104 from turning on by adding (via DC add circuit 402) a positive or negative DC value to the audio signal, to block (via signal masking circuit 806) an output signal from the modulator (e.g., force P or N high or low as described above), and/or to apply a feedback voltage from the short-circuit feedback circuit 924.

FIG. 11 shows an example implementation of the load diagnostics circuit 408. The load diagnostics circuit 408 includes logic circuit 1110 and current sources 1101-1104. Current sources 1101 and 1102 are coupled to the output node 222 of the H-bridge, and current sources 1103 and 1104 are coupled to the output node 224 of the H-bridge. Each current source can be independently turned on and off by the logic circuit 1110. A short-circuit detection test is performed by the logic circuit 1110 when the transistors 202-208 of the H-bridge are turned off. The short-circuit detection test can be performed at system startup or during run-time when no audio is being played through the speaker.

The speaker 106 has a resistance designated as Rspkr in FIG. 11. A current forced through the speaker will result in a certain voltage across the speaker's terminals based on the size of Rspkr. In this example, the current produced by each of the four current sources 1101-1104 is I. In one example, the short-circuit detection test is performed in two steps. First, current sources 1101 and 1104 are turned on, with current sources 1102 and 1103 off. Then, current sources 1102 and 1103 are turned on, with current sources 1101 and 1104 off.

With current sources 1101 and 1104 on, current I will flow from current source 1101, through Rspkr, and to ground through current source 1104. In the absence of a short-circuit on either of output nodes 222 or 224, the current through Rspkr will be I. Thus, the differential voltage (Vdiff) across Rspkr will be I*Rspkr. Both and I and Rspkr are known apriori, and thus Vdiff will be within a predicted voltage range in the absence of a short-circuit condition The common mode voltage (VCM) between output nodes 222 and 224 will be (V222+V224)/2, where V222 is the voltage on output node 222 relative to ground and V224 is the voltage on output node 224 relative to ground. With no short-circuit, VCM is PVDD/2.

However, and still with current sources 1101 and 1104 on, if output node 222 is shorted to ground, then V222 will be 0 V (due to the short-circuit) and V224 will be 0 V due to current source 1104 being and having a relatively small voltage drop from ground to output node 224. In this stage (output node 222 shorted to ground), both Vdiff and VCM will be approximately equal to 0 V. Instead of output node 222 being shorted to ground, if output node 224 is shorted to PVDD, V224 will be equal to PVDD due the short-circuit and V222 will be approximately equal PVDD due to current source 1101 being on. In this latter case (short between output node 224 and PVDD), Vdiff will be equal to 0 V and VCM will be equal to PVDD. As such, with current sources 1101 and 1104 being, a short-circuit can be detected from output node 222 to ground or form output node 224 to PVDD.

The other short-circuit conditions are output node 222 being shorted to PVDD and output node 224 shorted to ground. If output node 222 is shorted to PVDD and current sources 1101 and 1104 are on, output node 222's voltage will be PVDD due to the short-circuit. Current I will flow through Rspkr and thus Vdiff will equal I*Rspkr. The voltage on output node 224 will equal PVDD-I*Rspkr, and thus VCM will equal (PVDD+PVDD-I*Rspkr)/2 which equals PVDD-I*Rspkr/2. If output node 224 is shorted to ground, current I will flow through Rspkr and Vdiff will equal I*Rspkr, and VCM will equal I*Rsprk/2.

A similar analysis can be performed if current sources 1102 and 1103 are on (and current sources 1101 and 1104 are off). Table I lists the various short-circuit conditions and the resulting differential and common mode voltages based on which pair of current sources are on.

**TABLE I.**

| | Current sources 1101 and 1104 on | | Current sources 1102 and 1103 on | |
|---|---|---|---|---|
| Condition | Vdiff | VCM | Vdiff | VCM |
| No short | I*Rspkr | PVDD/2 | - I*Rspkr | VDD/2 |
| 222 short to PVDD | I*Rspkr | PVDD-I*Rsprk/2 | 0 | PVDD |
| 222 short to gnd | 0 | 0 | - I*Rspkr | I*Rsprk/2 |
| 224 short to PVDD | 0 | PVDD | -I*Rspkr | PVDD-I*Rsprk/2 |
| 224 short to gnd | I*Rspkr | I*Rspkr/2 | 0 | 0 |
| Open Load | PVDD | PVDD/2 | -PVDD | PVDD/2 |

The logic circuit 1110 monitors the voltages on output nodes 222 and 224 when current sources 1101 and 1104 are on and again when current sources 1102 and 1103 are on. Based on the voltages and as described above, the logic circuit 1110 can detect whether a short-circuit is present and the type of short-circuit (output node 222 shorted to PVDD or to ground; output node 224 shorted to PVDD or to ground).

Any of the examples described herein can be implemented on an integrated circuit. For example, each of the examples shown in FIGS. 1 (except for the speaker), 4, 5, 8, 9, and 10 can be fabricated as integrated circuits.

The term "couple" is used throughout the specification. The term may cover connections, communications, or signal paths that enable a functional relationship consistent with the description of this description. For example, if device A generates a signal to control device B to perform an action, in a first example device A is coupled to device B, or in a second example device A is coupled to device B through intervening component C if intervening component C does not substantially alter the functional relationship between device A and device B such that device B is controlled by device A via the control signal generated by device A.

Modifications are possible in the described embodiments, and other embodiments are possible, within the scope of the claims.

## Claims

1. An audio system, comprising:
a modulator (102) having an input and an output;
an H-bridge (104) having an input and an output, the output of the modulator (102) coupled to the input of the H-bridge (104);
a load diagnostics circuit (408) having an input and a first control output, the load diagnostics circuit input coupled to the output of the H-bridge (104); and
a direct current DC add circuit (402) having an input and an output, the output of the DC add circuit is coupled to the input of the modulator (102), and the first control output from the load diagnostics circuit (408) is coupled to the input of the DC add circuit (402);
wherein the load diagnostics circuit (408) is configured to detect a short-circuit condition on the output of the H-bridge (104) and, in response, to assert the control signal to the DC add circuit (402) to add a DC voltage to an audio input signal to avoid that a respective transistor of the H-bridge (104) is turned on which would result in a short condition between ground and supply voltage.

2. The audio system of claim 1, wherein the DC add circuit (402) is configured to receive the audio input signal on its input and to selectively add the DC voltage to the audio input signal in response to a control signal on the first control output from the load diagnostics circuit (408).

3. The audio system of claim 2, wherein:
the output of the H-bridge (104) includes a first output terminal and a second output terminal; and
the load diagnostics circuit (408) is configured to selectively detect a type of short-circuit on the output of the H-bridge (104), the type including the first output terminal being shorted to a power supply voltage terminal, the first output terminal being shorted to a ground, the second output terminal being shorted to the power supply voltage terminal, or the second output terminal being shorted to ground.

4. The audio system of claim 1, wherein the load diagnostic circuit (408) is configured to assert the control signal based on the detected type of short-circuit, and the DC add circuit (402) is configured to selectively add a positive DC value to the audio input signal responsive to a first state of the control signal or add a negative DC value to the audio input signal responsive to a second state of the control signal.

5. The audio system of claim 1, further including a signal masking circuit coupled between the modulator (102) and the H-bridge (104), wherein:
the load diagnostics circuit (408) includes a second control output;
the signal masking circuit includes a control input coupled to the second control output;
the input of the H-bridge (104) includes a first H-bridge input and a second H-bridge input;
the signal masking circuit is configured to force a signal on one of the first and second H-bridge inputs to a fixed logic state responsive to a control signal on the load diagnostic circuit's second control output.

6. An audio system of claim 1, further comprising:
a signal masking circuit coupled between the output of the modulator (102) and the input of the H-bridge (104), the signal masking circuit including a control input coupled to the first control output of the load diagnostics circuit (408);
wherein the load diagnostics circuit (408) is configured to detect a short-circuit condition on the output of the H-bridge (104) and, in response, control the signal masking circuit via the control input to mask the output from the modulator (102) to avoid that the detected short-circuit condition results in a short condition between ground and supply voltage.

7. The audio system of claim 6, wherein:
the input of the H-bridge (104) includes a first H-bridge input and a second H-bridge input; and
the signal masking circuit is configured to force a signal on one of the first and second H-bridge inputs to a fixed logic state responsive to a control signal on the load diagnostic circuit's first control output.

8. The audio system of claim 7, wherein the output of the modulator (102) includes a first modulator output and a second modulator output, and wherein the signal masking circuit includes:
a first multiplexer having first through third inputs and a first selection input, the first input of the first multiplexer coupled to the first modulator output, the second input of the first multiplexer configured to receive a fixed logic high, the third input of the first multiplexer configured to receive a fixed logic low, and the first selection input coupled to the first control output of the load diagnostics circuit (408); and
a second multiplexer having first through third inputs and a second selection input, the first input of the second multiplexer coupled to the second modulator output, the second input of the second multiplexer configured to receive a fixed logic high, the third input of the second multiplexer configured to receive a fixed logic low, and the second selection input coupled to the first control output of the load diagnostics circuit (408);
the input of the H-bridge (104) includes a first H-bridge input and a second H-bridge input; optionally wherein the input of the H-bridge includes a first H-bridge input and a second H-bridge input, and wherein an output of the first multiplexer coupled to the first H-bridge input and an output of the second multiplexer is coupled to the second H-bridge input.

9. The audio system of claim 6, further including:
a direct current DC add circuit (402) having an input and an output, the output of the DC add circuit (402) is coupled to the input of the modulator (102), and a second control output from the load diagnostics circuit (408) is coupled to the DC add circuit (402), the DC add circuit (402) is configured to add, responsive to a signal on the second control output form the load diagnostic circuit, a DC voltage to an input signal on the input of the DC add circuit (402).

10. The audio system of claim 6, further including:
a short-circuit feedback circuit having an input and an output, the input of the short-circuit feedback circuit coupled to the output of the modulator (102); and
a first switch coupled between the output of the short-circuit feedback circuit and the input of the modulator (102); and
a second switch coupled between the output of the H-bridge (104) and the input of the modulator (102);
wherein the first and second switches are configured to change their operational state based on control signals from the load diagnostics circuit (408); wherein the H-bridge (104) has an output impedance and the short-circuit feedback circuit has an output impedance, and the output impedance of the short-circuit feedback circuit is greater than the output impedance of the H-bridge (104).

11. An audio system, comprising:
a modulator (102) having an input and an output;
an H-bridge (104) having an input and an output;
a short-circuit feedback circuit having an input and an output, the input of the short-circuit feedback circuit coupled to the output of the modulator (102); and
a first switch coupled between the output of the short-circuit feedback circuit and the input of the modulator (102);
a second switch coupled between the output of the H-bridge (104) and the input of the modulator (102); and
a load diagnostics circuit (408) having an input coupled to the output of the H-bridge (104), the load diagnostics circuit (408) configured to control operational states of the first and second switches;
wherein the load diagnostics circuit (408) is configured to detect a short-circuit on the output of the H-bridge (104) and, in responsive to the detected short-circuit, open the second switch and close the first switch and wherein the H-bridge (104) has an output impedance and the short-circuit feedback circuit has an output impedance, and the output impedance of the short-circuit feedback circuit is greater than the output impedance of the H-bridge (104).

12. The audio system of claim 11, further including: a signal masking circuit coupled between the output of the modulator (102) and the input of the H-bridge (104), the signal masking circuit including a control input coupled to a control output of the load diagnostics circuit (408).

13. The audio system of claim 11, further including: a direct current DC add circuit (402) having an input and an output, the output of the DC add circuit (402) is coupled to the input of the modulator (102), and a control output from the load diagnostics circuit (408) is coupled to the DC add circuit (402), the DC add circuit (402) is configured to add, responsive to a signal on the control output form the load diagnostic circuit, a DC value to an input signal on the input of the DC add circuit (402); wherein the DC add circuit (402) is configured to selectively add a positive or negative DC value to the input signal on the input of the DC add circuit (402) based on the signal on the control output form the load diagnostic circuit.

## Patentansprüche

1. Audiosystem, das umfasst:
einen Modulator (102) mit einem Eingang und einem Ausgang;
eine H-Brücke (104) mit einem Eingang und einem Ausgang, wobei der Ausgang des Modulators (102) mit dem Eingang der H-Brücke (104) gekoppelt ist;
eine Lastdiagnoseschaltung (408) mit einem Eingang und einem ersten Steuerausgang, wobei der Lastdiagnoseschaltungseingang mit dem Ausgang der H-Brücke (104) gekoppelt ist; und
eine Gleichstrom(DC)-Addierschaltung (402) mit einem Eingang und einem Ausgang, wobei der Ausgang der Gleichstromaddierschaltung mit dem Eingang des Modulators (102) gekoppelt ist und der erste Steuerausgang von der Lastdiagnoseschaltung (408) mit dem Eingang der Gleichstromaddierschaltung (402) gekoppelt ist;
wobei die Lastdiagnoseschaltung (408) dazu ausgelegt ist, eine Kurzschlussbedingung am Ausgang der H-Brücke (104) zu detektieren und als Reaktion darauf das Steuersignal an die Gleichstromaddierschaltung (402) aktiv zu setzen, um eine Gleichspannung zu einem Audioeingangssignal zu addieren, um zu vermeiden, dass ein jeweiliger Transistor der H-Brücke (104) eingeschaltet wird, was zu einer Kurzschlussbedingung zwischen Masse und Versorgungsspannung führen würde.

2. Audiosystem nach Anspruch 1, wobei die Gleichstromaddierschaltung (402) dazu ausgelegt ist, das Audioeingangssignal an ihrem Eingang zu empfangen und selektiv die Gleichspannung als Reaktion auf ein Steuersignal am ersten Steuerausgang von der Lastdiagnoseschaltung (408) zum Audioeingangssignal zu addieren.

3. Audiosystem nach Anspruch 2, wobei:
der Ausgang der H-Brücke (104) einen ersten Ausgangsanschluss und einen zweiten Ausgangsanschluss einschließt und
die Lastdiagnoseschaltung (408) dazu ausgelegt ist, selektiv einen Typ eines Kurzschlusses am Ausgang der H-Brücke (104) zu detektieren, wobei der Typ einschließt, dass der erste Ausgangsanschluss mit einem Leistungsversorgungsspannungsanschluss kurzgeschlossen ist,
wobei der erste Ausgangsanschluss mit einer Masse kurzgeschlossen ist, wobei der zweite Ausgangsanschluss mit dem Leistungsversorgungsspannungsanschluss kurzgeschlossen ist oder der zweite Ausgangsanschluss mit Masse kurzgeschlossen ist.

4. Audiosystem nach Anspruch 1, wobei die Lastdiagnoseschaltung (408) dazu ausgelegt ist, das Steuersignal basierend auf dem detektierten Kurzschlusstyp aktiv zu setzen, und die Gleichstromaddierschaltung (402) dazu ausgelegt ist, als Reaktion auf einen ersten Zustand des Steuersignals selektiv einen positiven Gleichstromwert zum Audioeingangssignal zu addieren oder als Reaktion auf einen zweiten Zustand des Steuersignals einen negativen Gleichstromwert zum Audioeingangssignal zu addieren.

5. Audiosystem nach Anspruch 1, das ferner eine Signalmaskierungsschaltung, die zwischen den Modulator (102) und die H-Brücke (104) gekoppelt ist, einschließt, wobei:
die Lastdiagnoseschaltung (408) einen zweiten Steuerausgang einschließt;
die Signalmaskierungsschaltung einen Steuereingang, der mit dem zweiten Steuerausgang gekoppelt ist, einschließt;
der Eingang der H-Brücke (104) einen ersten H-Brücken-Eingang und einen zweiten H-Brücken-Eingang einschließt;
die Signalmaskierungsschaltung dazu ausgelegt ist, ein Signal an einem vom ersten und vom zweiten H-Brücken-Eingang als Reaktion auf ein Steuersignal am zweiten Steuerausgang der Lastdiagnoseschaltung in einen festen Logikzustand zu zwingen.

6. Audiosystem nach Anspruch 1, das ferner umfasst:
eine Signalmaskierungsschaltung, die zwischen den Ausgang des Modulators (102) und den Eingang der H-Brücke (104) gekoppelt ist, wobei die Signalmaskierungsschaltung einen Steuereingang, der mit dem ersten Steuerausgang der Lastdiagnoseschaltung (408) gekoppelt ist, einschließt;
wobei die Lastdiagnoseschaltung (408) dazu ausgelegt ist, eine Kurzschlussbedingung am Ausgang der H-Brücke (104) zu detektieren und als Reaktion darauf die Signalmaskierungsschaltung über den Steuereingang zu steuern, um den Ausgang von dem Modulator (102) zu maskieren, um zu vermeiden, dass die detektierte Kurzschlussbedingung zu einer Kurzschlussbedingung zwischen Masse und Versorgungsspannung führt.

7. Audiosystem nach Anspruch 6, wobei:
der Eingang der H-Brücke (104) einen ersten H-Brücken-Eingang und einen zweiten H-Brücken-Eingang einschließt und
die Signalmaskierungsschaltung dazu ausgelegt ist, ein Signal an einem vom ersten und vom zweiten H-Brücken-Eingang als Reaktion auf ein Steuersignal am ersten Steuerausgang der Lastdiagnoseschaltung in einen festen Logikzustand zu zwingen.

8. Audiosystem nach Anspruch 7, wobei der Ausgang des Modulators (102) einen ersten Modulatorausgang und einen zweiten Modulatorausgang einschließt und wobei die Signalmaskierungsschaltung einschließt:
einen ersten Multiplexer mit einem ersten bis einem dritten Eingang und einem ersten Auswahleingang, wobei der erste Eingang des ersten Multiplexers mit dem ersten Modulatorausgang gekoppelt ist, der zweite Eingang des ersten Multiplexers zum Empfangen eines festen logisch hohen Pegels ausgelegt ist, der dritte Eingang des ersten Multiplexers zum Empfangen eines festen logisch niedrigen Pegels ausgelegt ist und der erste Auswahleingang mit dem ersten Steuerausgang der Lastdiagnoseschaltung (408) gekoppelt ist; und
einen zweiten Multiplexer mit einem ersten bis einem dritten Eingang und einem zweiten Auswahleingang, wobei der erste Eingang des zweiten Multiplexers mit dem zweiten Modulatorausgang gekoppelt ist, der zweite Eingang des zweiten Multiplexers zum Empfangen eines festen logisch hohen Pegels ausgelegt ist, der dritte Eingang des zweiten Multiplexers zum Empfangen eines festen logisch niedrigen Pegels ausgelegt ist und der zweite Auswahleingang mit dem ersten Steuerausgang der Lastdiagnoseschaltung (408) gekoppelt ist;
wobei der Eingang der H-Brücke (104) einen ersten H-Brücken-Eingang und einen zweiten H-Brücken-Eingang einschließt; wobei optional der Eingang der H-Brücke einen ersten H-Brücken-Eingang und einen zweiten H-Brücken-Eingang einschließt und wobei ein Ausgang des ersten Multiplexers mit dem ersten H-Brücken-Eingang gekoppelt ist und ein Ausgang des zweiten Multiplexers mit dem zweiten H-Brücken-Eingang gekoppelt ist.

9. Audiosystem nach Anspruch 6, das ferner einschließt:
eine Gleichstrom(DC)-Addierschaltung (402) mit einem Eingang und einem Ausgang, wobei der Ausgang der Gleichstromaddierschaltung (402) mit dem Eingang des Modulators (102) gekoppelt ist und ein zweiter Steuerausgang von der Lastdiagnoseschaltung (408) mit der Gleichstromaddierschaltung (402) gekoppelt ist, wobei die Gleichstromaddierschaltung (402) dazu ausgelegt ist, als Reaktion auf ein Signal am zweiten Steuerausgang von der Lastdiagnoseschaltung eine Gleichspannung zu einem Eingangssignal am Eingang der Gleichstromaddierschaltung (402) zu addieren.

10. Audiosystem nach Anspruch 6, das ferner einschließt:
eine Kurzschlussrückkopplungsschaltung mit einem Eingang und einem Ausgang, wobei der Eingang der Kurzschlussrückkopplungsschaltung mit dem Ausgang des Modulators (102) gekoppelt ist; und
einen ersten Schalter, der zwischen den Ausgang der Kurzschlussrückkopplungsschaltung und den Eingang des Modulators (102) gekoppelt ist; und
einen zweiten Schalter, der zwischen den Ausgang der H-Brücke (104) und den Eingang des Modulators (102) gekoppelt ist;
wobei der erste und der zweite Schalter dazu ausgelegt sind, ihren Betriebszustand basierend auf Steuersignalen von der Lastdiagnoseschaltung (408) zu ändern; wobei die H-Brücke (104) eine Ausgangsimpedanz aufweist und die Kurzschlussrückkopplungsschaltung eine Ausgangsimpedanz aufweist und die Ausgangsimpedanz der Kurzschlussrückkopplungsschaltung größer als die Ausgangsimpedanz der H-Brücke (104) ist.

11. Audiosystem, das umfasst:
einen Modulator (102) mit einem Eingang und einem Ausgang;
eine H-Brücke (104) mit einem Eingang und einem Ausgang;
eine Kurzschlussrückkopplungsschaltung mit einem Eingang und einem Ausgang, wobei der Eingang der Kurzschlussrückkopplungsschaltung mit dem Ausgang des Modulators (102) gekoppelt ist; und
einen ersten Schalter, der zwischen den Ausgang der Kurzschlussrückkopplungsschaltung und den Eingang des Modulators (102) gekoppelt ist;
einen zweiten Schalter, der zwischen den Ausgang der H-Brücke (104) und den Eingang des Modulators (102) gekoppelt ist; und
eine Lastdiagnoseschaltung (408) mit einem Eingang, der mit dem Ausgang der H-Brücke (104) gekoppelt ist, wobei die Lastdiagnoseschaltung (408) dazu ausgelegt ist, Betriebszustände des ersten und des zweiten Schalters zu steuern;
wobei die Lastdiagnoseschaltung (408) dazu ausgelegt ist, einen Kurzschluss am Ausgang der H-Brücke (104) zu detektieren und als Reaktion auf den detektierten Kurzschluss den zweiten Schalter zu öffnen und den ersten Schalter zu schließen, und wobei die H-Brücke (104) eine Ausgangsimpedanz aufweist und die Kurzschlussrückkopplungsschaltung eine Ausgangsimpedanz aufweist und die Ausgangsimpedanz der Kurzschlussrückkopplungsschaltung größer als die Ausgangsimpedanz der H-Brücke (104) ist.

12. Audiosystem nach Anspruch 11, das ferner einschließt: eine Signalmaskierungsschaltung, die zwischen den Ausgang des Modulators (102) und den Eingang der H-Brücke (104) gekoppelt ist, wobei die Signalmaskierungsschaltung einen Steuereingang, der mit einem ersten Steuerausgang der Lastdiagnoseschaltung (408) gekoppelt ist, einschließt.

13. Audiosystem nach Anspruch 11, das ferner einschließt: eine Gleichstrom(DC)-Addierschaltung (402) mit einem Eingang und einem Ausgang, wobei der Ausgang der Gleichstromaddierschaltung (402) mit dem Eingang des Modulators (102) gekoppelt ist, und ein Steuerausgang von der Lastdiagnoseschaltung (408) mit der Gleichstromaddierschaltung (402) gekoppelt ist, die Gleichstromaddierschaltung (402) dazu ausgelegt ist, als Reaktion auf ein Signal am Steuerausgang von der Lastdiagnoseschaltung einen Gleichstromwert zu einem Eingangssignal am Eingang der Gleichstromaddierschaltung (402) zu addieren; wobei die Gleichstromaddierschaltung (402) dazu ausgelegt ist, selektiv einen positiven oder einen negativen Gleichstromwert zum Eingangssignal am Eingang der Gleichstromaddierschaltung (402) basierend auf dem Signal am Steuerausgang von der Lastdiagnoseschaltung zu addieren.

## Revendications

1. Système audio, comprenant :
un modulateur (102) comportant une entrée et une sortie ;
un pont en H (104) comportant une entrée et une sortie, la sortie du modulateur (102) étant couplée à l'entrée du pont en H (104) ;
un circuit de diagnostic de charge (408) comportant une entrée et une première sortie de commande, l'entrée du circuit de diagnostic de charge étant couplée à la sortie du pont en H (104) ; et
un circuit d'addition de courant continu (402) comportant une entrée et une sortie, la sortie du circuit d'addition de courant continu étant couplée à l'entrée du modulateur (102), et la première sortie de commande du circuit de diagnostic de charge (408) étant couplée à l'entrée du circuit d'addition de courant continu (402) ;
le circuit de diagnostic de charge (408) étant configuré pour détecter une condition de court-circuit à la sortie du pont en H (104) et, en réponse, pour activer le signal de commande vers le circuit d'addition de courant continu (402) afin d'ajouter une tension continue à un signal d'entrée audio pour éviter qu'un transistor respectif du pont en H (104) ne soit rendu passant, ce qui conduirait à une condition de court-circuit entre la masse et la tension d'alimentation.

2. Système audio selon la revendication 1, le circuit d'addition de courant continu (402) étant configuré pour recevoir le signal d'entrée audio sur son entrée et pour ajouter sélectivement la tension continue au signal d'entrée audio en réponse à un signal de commande sur la première sortie de commande provenant du circuit de diagnostic de charge (408).

3. Système audio selon la revendication 2,
la sortie du pont en H (104) comprenant une première borne de sortie et une seconde borne de sortie ; et
le circuit de diagnostic de charge (408) étant configuré pour détecter sélectivement un type de court-circuit à la sortie du pont en H (104), le type dans lequel la première borne de sortie est court-circuitée à une borne de tension d'alimentation, la première borne de sortie est court-circuitée à la masse, la seconde borne de sortie est court-circuitée à la borne de tension d'alimentation, ou la seconde borne de sortie est court-circuitée à la masse.

4. Système audio selon la revendication 1, le circuit de diagnostic de charge (408) étant configuré pour activer le signal de commande sur la base du type détecté de court-circuit, et le circuit d'addition de courant continu (402) étant configuré pour ajouter sélectivement une valeur de courant continu positive au signal d'entrée audio en réponse à un premier état du signal de commande ou pour ajouter une valeur de courant continu négative au signal d'entrée audio en réponse à un second état du signal de commande.

5. Système audio selon la revendication 1, comprenant en outre un circuit de masquage de signal couplé entre le modulateur (102) et le pont en H (104) :
le circuit de diagnostic de charge (408) comportant une seconde sortie de commande ;
le circuit de masquage de signal comportant une entrée de commande couplée à la seconde sortie de commande ;
l'entrée du pont en H (104) comportant une première entrée de pont en H et une deuxième entrée de pont en H ;
le circuit de masquage de signal étant configuré pour forcer un signal sur l'une des première et deuxième entrées de pont en H à un état logique fixe en réponse à un signal de commande sur la seconde sortie de commande du circuit de diagnostic de charge.

6. Système audio selon la revendication 1, comprenant en outre :
un circuit de masquage de signal couplé entre la sortie du modulateur (102) et l'entrée du pont en H (104), le circuit de masquage de signal comportant une entrée de commande couplée à la première sortie de commande du circuit de diagnostic de charge (408) ;
le circuit de diagnostic de charge (408) étant configuré pour détecter une condition de court-circuit à la sortie du pont en H (104) et, en réponse, pour commander le circuit de masquage de signal par l'intermédiaire de l'entrée de commande pour masquer la sortie du modulateur (102) afin d'éviter que la condition de court-circuit détectée ne conduise à une condition de court-circuit entre la masse et la tension d'alimentation.

7. Système audio selon la revendication 6 :
l'entrée du pont en H (104) comprenant une première entrée de pont en H et une deuxième entrée de pont en H ; et
le circuit de masquage de signal étant configuré pour forcer un signal sur l'une des première et deuxième entrées de pont en H à un état logique fixe en réponse à un signal de commande sur la première sortie de commande du circuit de diagnostic de charge.

8. Système audio selon la revendication 7, la sortie du modulateur (102) comprenant une première sortie de modulateur et une seconde sortie de modulateur, et le circuit de masquage de signal comprenant :
un premier multiplexeur comportant des première à troisième entrées et une première entrée de sélection, la première entrée du premier multiplexeur étant couplée à la première sortie de modulateur, la deuxième entrée du premier multiplexeur étant configurée pour recevoir un niveau logique haut fixe, la troisième entrée du premier multiplexeur étant configurée pour recevoir un niveau logique bas fixe, et la première entrée de sélection étant couplée à la première sortie de commande du circuit de diagnostic de charge (408) ; et
un second multiplexeur comportant des première à troisième entrées et une deuxième entrée de sélection, la première entrée du second multiplexeur étant couplée à la seconde sortie de modulateur, la deuxième entrée du second multiplexeur étant configurée pour recevoir un niveau logique haut fixe, la troisième entrée du second multiplexeur étant configurée pour recevoir un niveau logique bas fixe, et la deuxième entrée de sélection étant couplée à la première sortie de commande du circuit de diagnostic de charge (408) ;
l'entrée du pont en H (104) comprenant une première entrée de pont en H et une deuxième entrée de pont en H ; facultativement,
l'entrée du pont en H comprenant une première entrée de pont en H et une deuxième entrée de pont en H, et une sortie du premier multiplexeur étant couplée à la première entrée de pont en H et une sortie du second multiplexeur étant couplée à la deuxième entrée de pont en H.

9. Système audio selon la revendication 6, comprenant en outre :
un circuit d'addition de courant continu (402) comportant une entrée et une sortie, la sortie du circuit d'addition de courant continu (402) étant couplée à l'entrée du modulateur (102), et une seconde sortie de commande du circuit de diagnostic de charge (408) étant couplée au circuit d'addition de courant continu (402), le circuit d'addition de courant continu (402) étant configuré pour ajouter, en réponse à un signal sur la seconde sortie de commande du circuit de diagnostic de charge, une tension continue à un signal d'entrée sur l'entrée du circuit d'addition de courant continu (402).

10. Système audio selon la revendication 6, comprenant en outre :
un circuit de rétroaction de court-circuit comportant une entrée et une sortie, l'entrée du circuit de rétroaction de court-circuit étant couplée à la sortie du modulateur (102) ; et
un premier commutateur couplé entre la sortie du circuit de rétroaction de court-circuit et l'entrée du modulateur (102) ; et
un second commutateur couplé entre la sortie du pont en H (104) et l'entrée du modulateur (102) ;
les premier et second commutateurs étant configurés pour changer leur état de fonctionnement sur la base de signaux de commande provenant du circuit de diagnostic de charge (408) ; le pont en H (104) comportant une impédance de sortie et le circuit de rétroaction de court-circuit comportant une impédance de sortie, et l'impédance de sortie du circuit de rétroaction de court-circuit étant supérieure à l'impédance de sortie du pont en H (104).

11. Système audio, comprenant :
un modulateur (102) comportant une entrée et une sortie ;
un pont en H (104) comportant une entrée et une sortie ;
un circuit de rétroaction de court-circuit comportant une entrée et une sortie, l'entrée du circuit de rétroaction de court-circuit étant couplée à la sortie du modulateur (102) ; et
un premier commutateur couplé entre la sortie du circuit de rétroaction de court-circuit et l'entrée du modulateur (102) ;
un second commutateur couplé entre la sortie du pont en H (104) et l'entrée du modulateur (102) ; et
un circuit de diagnostic de charge (408) comportant une entrée couplée à la sortie du pont en H (104), le circuit de diagnostic de charge (408) étant configuré pour commander des états de fonctionnement des premier et second commutateurs ;
le circuit de diagnostic de charge (408) étant configuré pour détecter un court-circuit à la sortie du pont en H (104) et, en réponse au court-circuit détecté, pour ouvrir le second commutateur et fermer le premier commutateur, et le pont en H (104) comportant une impédance de sortie et le circuit de rétroaction de court-circuit comportant une impédance de sortie, et l'impédance de sortie du circuit de rétroaction de court-circuit étant supérieure à l'impédance de sortie du pont en H (104).

12. Système audio selon la revendication 11, comprenant en outre : un circuit de masquage de signal couplé entre la sortie du modulateur (102) et l'entrée du pont en H (104), le circuit de masquage de signal comprenant une entrée de commande couplée à une sortie de commande du circuit de diagnostic de charge (408).

13. Système audio selon la revendication 11, comprenant en outre : un circuit d'addition de courant continu (402) comportant une entrée et une sortie, la sortie du circuit d'addition de courant continu (402) étant couplée à l'entrée du modulateur (102), et une sortie de commande du circuit de diagnostic de charge (408) étant couplée au circuit d'addition de courant continu (402), le circuit d'addition de courant continu (402) étant configuré pour ajouter, en réponse à un signal sur la sortie de commande du circuit de diagnostic de charge, une valeur de courant continu à un signal d'entrée sur l'entrée du circuit d'addition de courant continu (402) ; le circuit d'addition de courant continu (402) étant configuré pour ajouter sélectivement une valeur de courant continu positive ou négative au signal d'entrée sur l'entrée du circuit d'addition de courant continu (402) sur la base du signal sur la sortie de commande du circuit de diagnostic de charge.
